# EUROPEAN PATENT APPLICATION

(11) **EP 1 816 454 A1**
(43) Date of publication of application: **08.08.2007**
(21) Application number: 05806757.0
(22) Date of filing: 17.11.2005
(51) Int. Cl.: G01J 1/02, H01L 35/32, H01L 37/00

(54) **INFRARED SENSOR**

(30) Priority: 24.11.2004 JP 2004339626
(71) Applicant: HAMAMATSU PHOTONICS K.K., Hamamatsu-shi, Shizuoka-ken 435-8558 (JP)
(72) Inventor: SHIBAYAMA, Katsumi, Hamamatsu Photonics K.K., Hamamatsu-shi, Shizuoka 4358558 (JP)
(74) Representative: Frost, Alex John
(86) International application number: PCT/JP2005/021098
(87) International publication number: WO 2006/057191

(57) **Abstract**

An object of the present invention is to provide an infrared detector that is strong against mechanical impacts and enables mounting for various applications to be carried out readily and reliably. An infrared detector 1 includes: a base member 10, positioned at a lower portion; an infrared detecting chip 20, mounted on the base member 10 and for detecting infrared rays; an optical window chip 30, positioned above the infrared detecting chip 20 and for transmitting infrared rays; and bonding wires 38, connecting terminals of the infrared detecting chip 20 with terminals of the base member 10, and a portion below a predetermined distance from an upper surface 30a of the optical window chip 30 is coated by a coating member 40. By interposition of a spacer 36, the optical window chip 30 and the infrared detecting chip 20 form a sealed space 34 that houses an infrared photosensitive portion 23.

## Description

### Technical Field

The present invention relates to an infrared detector and particularly to a thermal infrared detector of a bolometer, thermopile, pyroelectric sensor, diode, or bimetal type.

### Background Art

As a thermal infrared detector of a bolometer, thermopile, pyroelectric sensor, diode, or bimetal type, for example, a detector described in Patent Document 1 is known. The infrared detector described in this document has a structure in which an optical window for infrared rays is disposed with a gap in front of a photosensitive portion formed on a silicon substrate, the optical window is fixed by being adhered in an airtight manner onto the substrate at an adhesion surface of a range that surrounds the photosensitive portion, and the interior of the gap is made into a vacuum.

However, in mounting onto another device, the above-described infrared detector is weak against mechanical impact, and in particular, the silicon substrate and wires connecting to external electrodes, etc., frequently become cut or flawed due to impact and mounting process faults occur frequently. The utmost care is thus required to mount the infrared detector, and this causes lowering of the yield of the process.
Patent Document 1: Japanese Patent Application Laid-Open No. H09-243449

### Disclosure of the Invention

### Problems to be Solved by the Invention

The present invention has been made in view of such problems and an object thereof is to provide an infrared detector that is strong against mechanical impacts and enables mounting for various applications to be carried out readily and reliably.

### Means for Solving the Problem

An infrared detector according to the present invention includes: an infrared detecting chip, having an infrared photosensitive portion and a signal input/output terminal connected to the photosensitive portion formed on a silicon substrate; an optical window chip, being fixed to a photosensitive side of the infrared detecting chip, forming a sealed space that exposes the signal input/output terminal and houses the photosensitive portion, and transmits at least infrared rays that are to be detected; a base member having a mounting surface for mounting the infrared detecting chip and provided with an internal lead terminal near the mounting surface; a bonding wire, electrically connecting the signal input/output terminal with the internal lead terminal; and a coating member, formed by injecting and hardening a resin so as to incorporate at least the signal input/output terminal, the internal lead terminal, and the bonding wire in its interior and coat at least the infrared detecting chip side of side surfaces of the optical window chip.

With this invention, because the bonding wires and other portions that tend to receive mechanical impacts readily are incorporated inside the coating member, the infrared detector is made high in impact resistance and mounting onto various devices can be carried out readily and reliably. Also, because by the coating member coating the side surfaces of the silicon substrate, the heat capacity of the silicon substrate is increased and the effects of external heat that may otherwise enter from the side surfaces of the silicon substrate are blocked, temperature variations are lowered and the infrared detector can be increased in sensitivity as a sensor. If the infrared detector according to the present invention is to be picked up by a pyramidal collet, because a suction portion of the collet contacts the coating member of the infrared detector and the suction portion thus does not contact an upper surface of the optical window chip directly, damage due to contact with the suction portion is prevented, thus contributing to improvement of the process yield.

With the infrared detector according to the present invention, a spacer may be interposed between the infrared detecting chip and the optical window chip so as to surround the sealed space. With this arrangement, because the sealed space between the infrared detecting chip and the optical window chip is made large in volume by just an amount corresponding to the thickness of the spacer and the heat insulating property of the infrared photosensitive portion is improved correspondingly, the sensitivity of the infrared detector can be improved. The spacer also serves a function of preventing inflow of the resin that is to become the coating member in an injection process and, when the resin hardens while shrinking, the infrared detecting chip and the optical window chip are drawn together to become improved in close adhesion property.

Preferably with the infrared detector according to the present invention, a recessed portion is formed on a surface of the optical window chip at the sealed space side. With this arrangement, because an even larger volume can be secured for the sealed space and the heat insulating property of the infrared photosensitive portion is improved further, the sensitivity of the infrared detector can be improved further. Because the sealed space can be secured even in a case where there is no spacer or a case where the spacer cannot be made high, the lowering of the sensitivity can be suppressed.

Also preferably with the infrared detector according to the present invention, the base member includes a substrate portion, having the mounting surface at the upper surface, and a wall plate portion, erected on the substrate portion and having a top surface that surpasses the upper surface of the optical window chip. With this arrangement, by the provision of the wall plate portion that surpasses the upper surface of the optical window chip, when the infrared detector according to the present invention is picked up, for example, by a flat collet, a tip surface of a suction portion contacts the top surface of the wall plate portion of the infrared detector and does not directly contact the upper surface of the optical window chip. Breakage due to contact with the suction portion is thus prevented, and a contribution is made toward improving the process yield.

Furthermore with the infrared detector according to the present invention, the internal lead terminal is preferably electrically connected to an external lead terminal disposed on a lower surface of the base member. With this arrangement, because the external lead terminals are disposed on the lower surface of the base member, mounting onto a circuit substrate, etc., can be performed readily and reliably.

### Effects of the Invention

With the present invention, an infrared detector that is strong against mechanical impacts and enables mounting for various applications to be carried out readily and reliably can be provided.

### Brief Description of the Drawings

[FIG 1] A sectional view of an arrangement of an infrared detector according to a first embodiment.
[FIG 2] An explanatory diagram of the infrared detector according to the first embodiment as viewed from a side from which infrared rays are made incident.
[FIG. 3] A figure including explanatory diagrams of a method for manufacturing the infrared detector according to the first embodiment.
[FIG 4] An explanatory diagram of a positional relationship of the infrared detector according to the first embodiment and a mounting collet.
[FIG. 5] A sectional view of an arrangement of an infrared detector according to a second embodiment.
[FIG 6] A sectional view of an arrangement of an infrared detector according to a third embodiment.
**[FIG. 7**] A figure including explanatory diagrams of a method for manufacturing the infrared detector according to the third embodiment.
[FIG 8] An explanatory diagram of a positional relationship of the infrared detector according to the third embodiment and a mounting collet.

### Description of Symbols

1, 50, 60 - infrared detector, 10, 52 - base member, 11, 56 - substrate portion, 12, 54 - internal lead terminal, 13 - mounting surface, 14 - wall plate portion, 20 - infrared detecting chip, 21 - silicon substrate, 23 - infrared photosensitive portion, 25 - signal input/output terminal, 30, 62 - optical window chip, 34, 61 - sealed space, 36 - spacer, 38 - bonding wire, 40, 58 - coating member, 42 - external lead terminal, 63 - recessed portion.

### Best Modes for Carrying Out the Invention

Thermopile type infrared detectors, which are preferred embodiments according to the present invention, shall now be described in detail with reference to the attached drawings. In the description, elements that are the same or equivalent shall be provided with the same symbol and redundant description shall be omitted.

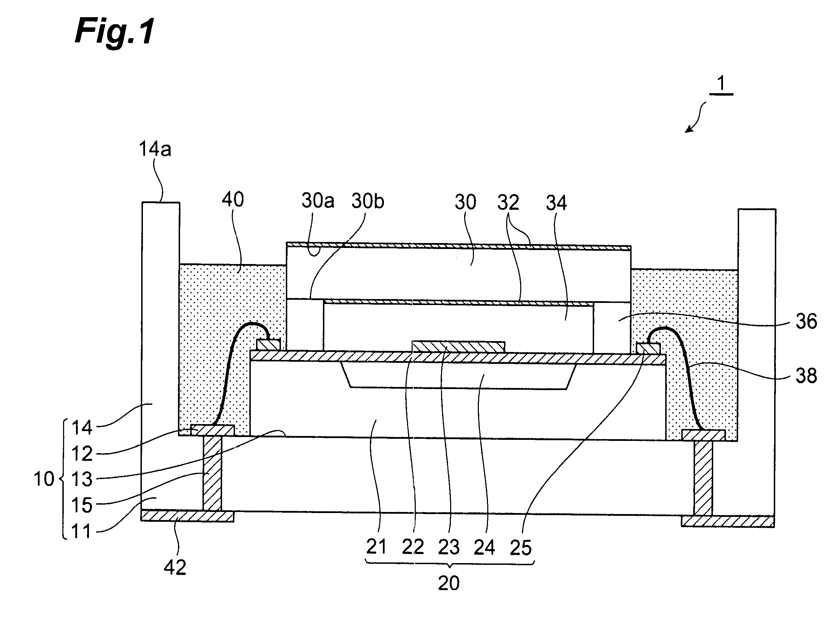

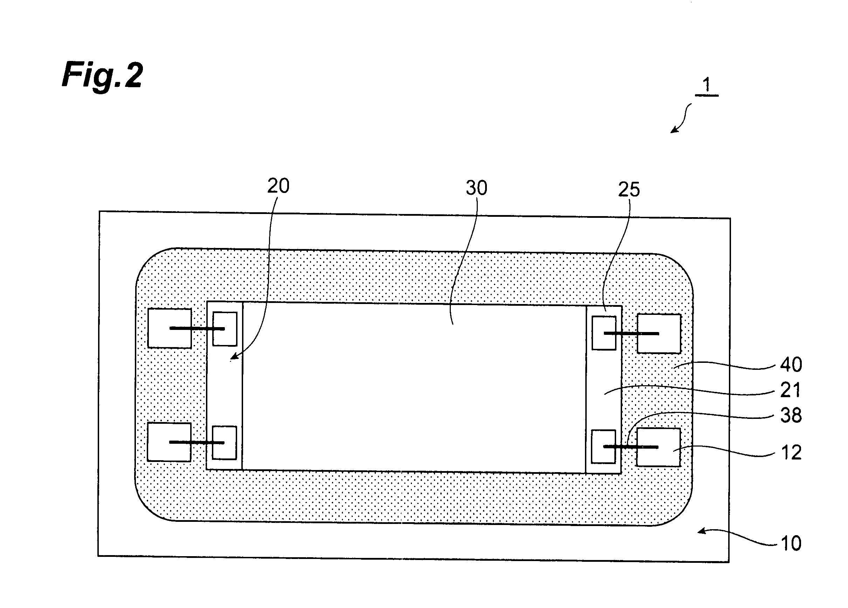

FIG. 1 is a sectional view of an arrangement of an infrared detector according to a first embodiment. FIG 2 is an explanatory diagram of the same as viewed from a side from which infrared rays are made incident. As shown in FIGS. 1 and 2, the infrared detector 1 includes a base member 10, which forms an outer enclosure that contains principal functional portions of this device, an infrared detecting chip 20, which detects infrared rays and is mounted on a mounting surface 13 of a substrate portion 11 that constitutes the base member 10, an optical window chip 30, which is disposed above the infrared detecting chip 20 and transmits infrared rays, and bonding wires 38, which connect terminals of the infrared detecting chip 20 and terminals of the base member 10. A characteristic point of the present embodiment is that a portion below a predetermined distance from an upper surface of the optical window chip 30 is coated by a coating member 40 formed by hardening a resin and the bonding wires 38 are incorporated in the interior thereof.

The base member 10 has a recessed space, an upper portion of which is open, and is constituted of a substrate portion 11 of flat, rectangular shape, positioned at a lower portion of the base member 10 and having a mounting surface 13 for mounting the infrared detecting chip 20, and a wall plate portion 14, erected at two longitudinal sides and two lateral sides of a periphery so as to surround the mounting surface 13. Near the mounting surface 13 of the substrate portion 11 are disposed land type internal lead terminals 12, connected to conducting portions 15 that penetrate through the substrate portion 11, and the conducting portions 15 are electrically connected to external lead terminals 42 disposed on a bottom surface (opposite surface of the mounting surface 13) of the base member 10. Because the external lead terminals 42 are electrically connected to the infrared detecting chip 20 via the bonding wires 38 and the conducting portions 15, the infrared detector 1 can be mounted onto a circuit substrate (not shown) readily and reliably. Although FR-4, FR-5, G-10 or other glass epoxy (epoxy resin having a glass fiber sheet as a core material) substrate, which is strong against heat released in a resin hardening process, is used in the base member 10, the base member 10 is not restricted thereto and other organic substrates, ceramic substrates, etc., may be used instead.

The infrared detecting chip 20 is mounted on the mounting surface 13 set on the upper surface of the substrate portion 11 of the base member 10, has a silicon substrate 21 as a base material, and includes an infrared photosensitive portion 23, signal input/output terminals 25, and a diaphragm portion 22 that forms a cavity portion 24. Specifically, the thin diaphragm portion 22 is formed at a center of the upper surface of the silicon substrate 21 as shown in FIG. 1. At peripheral edges of the upper surface of the silicon substrate 21 are disposed the signal input/output terminals (electrode pads) 25 that are electrically connected by aluminum wiring, etc., for taking out electrical output signals obtained at the infrared photosensitive portion 23.

A method for forming the diaphragm portion 22 and the cavity portion 24 shall now be described. First, a sacrificial layer (not shown), formed of polysilicon, etc., and being of the same size as the cavity portion 24, is formed on the upper surface of the silicon substrate 21, and a thin film that is to become the diaphragm portion 22 is formed on the sacrificial layer. The thin film is provided with etching holes (not shown) that are used in etching the sacrificial layer. An etching solution, such as a potassium hydroxide solution, etc., is made to permeate through the etching holes to etch the sacrificial layer isotropically, and thereafter, the silicon substrate 21 is removed by anisotropic etching. The cavity portion 24 of inverted trapezoidal pyramid shape for heat separation is formed in the removed portion. The thin film portion covering the upper surface of the cavity portion 24 becomes the diaphragm portion 22. The cavity portion 24 thermally insulates the infrared photosensitive portion 23 from below and is put in a vacuum state or is filled with an inert gas.

The silicon substrate 21 is preferably formed of a monocrystalline substrate with a (100) plane orientation. In this case, the upper surface of the silicon substrate 21 can be made a (100) plane that can be etched readily in the vertical direction, which is the direction of incidence of infrared rays, and the cavity portion 24 can thus be formed readily. The forming method and the shape of the cavity portion 24 are not restricted to the above, and as long as the desired diaphragm 22 can be formed, a method based on isotropic etching may be used, that is, an SOI wafer or other plane orientation wafer besides a (100) plane wafer may be used instead.

A plurality of serially connected thermocouple hot contacts (not shown) are disposed in the infrared photosensitive portion 23. A thermocouple is a temperature sensor having two types of metals connected in series to form two junctions and makes use of the principle of the "Seebeck effect," with which a thermoelectromotive force is generated according to a temperature difference that arises between the two junctions (hot contact and cold contact). Although not illustrated, in the present embodiment, hot contacts (temperature measurement contacts) and cold contacts (reference contacts) are formed from polysilicon and aluminum, respectively, the hot contacts are disposed on the diaphragm portion 22, the cold contacts are disposed on the silicon substrate 21, and the thermoelectromotive force between these is measured.

The optical window chip 30 has flat, rectangular shape that is smaller than the infrared detecting chip 20, is positioned at a photosensitive side (upper side) of the infrared detecting chip 20, and exposes the signal input/output terminals 25. Although not illustrated, the signal input/output terminals 25 are electrically connected to a sealed space 34 side via aluminum or other electrical wiring. Upper and lower surfaces of the electrical wiring positioned at a spacer 36 are preferably insulated electrically. An upper surface 30a of the optical window chip 30 that is fixed above the infrared detecting chip 20 via the spacer 36 is positioned lower than a top surface 14a of the wall plate portion 14. By the infrared detecting chip 20 and the optical window chip 30 opposing each other via the spacer 36, the sealed space 34 that houses the infrared photosensitive portion 23 is formed.

The sealed space 34 acts as a heat insulating layer, the hollow space is connected to the cavity portion 24 of the infrared detecting chip 20 via the etching holes formed in the diaphragm portion 22, and by a heat separating structure thus being formed so as to surround the infrared photosensitive portion 23, the sensitivity of the thermocouples inside the infrared photosensitive portion 23 is improved and the degree of heat separation of the infrared photosensitive portion 23 is improved. For heat insulation of the infrared photosensitive portion 23 from the surroundings, the sealed space 34 is put in the vacuum state or filled with the inert gas and made substantially the same in pressure as the cavity portion 24 of the infrared detecting chip 20.

The spacer 36 serves a role of preventing inflow of resin into the sealed space 34 in a process of injecting a resin that is to become the coating member 40, and by the injected resin hardening upon shrinking, an effect of improving the close adhesion property is provided. The material of the spacer 36 may be a resin-based material, such as epoxy, acryl, urethane, polyimide, etc., a glass material, such as Pyrex (registered trademark), low melting point glass, etc., a ceramic material, such as alumina, aluminum nitride, etc., a metal or alloy, such as aluminum, gold, nickel, tungsten silicide, etc., or a solder material, such as gold-tin alloy. When a solder material is used as the spacer 36, good close adhesion is provided by forming metal films in advance on the surfaces of both the silicon substrate 21 and the optical window chip 30. Also, a lamination of spacer materials may be employed to increase the height of the spacer 36.

Because the optical window chip 30 must exhibit a function of transmitting light of a bandwidth that includes the infrared rays to be detected, it is preferably formed of a silicon material, etc., of excellent transmittance at a transmittance wavelength range of 1.5 to 20 µm. Preferably, infrared anti-reflection films 32 are disposed on both surfaces 30a and 30b of the optical window chip 30 to enable reduction of reflection loss of infrared rays and improvement of the sensitivity of the infrared detector 1 to infrared rays. The infrared anti-reflection films 32 can be formed readily by a known vapor deposition method, sputter method, thermal oxidation method, etc. Infrared ray filter films, which selectively transmit infrared rays of specific wavelength, may be disposed in place of the infrared anti-reflection films 32.

As shown in FIG. 1, each bonding wire 38 is spanned across a signal input/output terminal 25, exposed on an upper surface (the surface at the outer side of the portion covered by the optical window chip 30) of the infrared detecting chip 20, and an internal lead terminal 12, disposed on an upper surface of the substrate portion 11 of the base member 10 and connects these components electrically. In the interior of the space formed by the base member 10 that functions as the outer enclosure, a portion below a predetermined distance from the upper surface 30a of the optical window chip 30 (0.2mm below the upper surface 30a of the optical window chip 30 in the present embodiment) is filled with the hardened resin. Because the bonding wires 38, which are, for example, thin gold wires, and the signal input/output terminals 25 and the internal lead terminals 12 connected to the bonding wires 38 are thus incorporated inside the coating member, the mechanically weak portions are protected by the coating member 40 and thereby strengthened in impact resistance, vibration resistance, etc. Also, because the upper surface (the surface at the outer side of the portion covered by the optical window chip 30) of the silicon substrate 21, which is the base material of the infrared detecting chip 20, and lower portions of the side surfaces of the optical window chip 30 are put in a state of being coated by the coating member 40, not only are impact resistance, vibration resistance, etc., improved but the coating member 40 also provides the effect of practically increasing the heat capacity of the infrared detecting chip 20 and blocking the influence of heat from the exterior.

The resin used as the coating member 40 may be a resin, such as silicone, epoxy, acryl, urethane, etc., or such a resin containing a composite material filler, and the resin may be colored or transparent. FIG. 2 shows a case where a transparent resin is used.

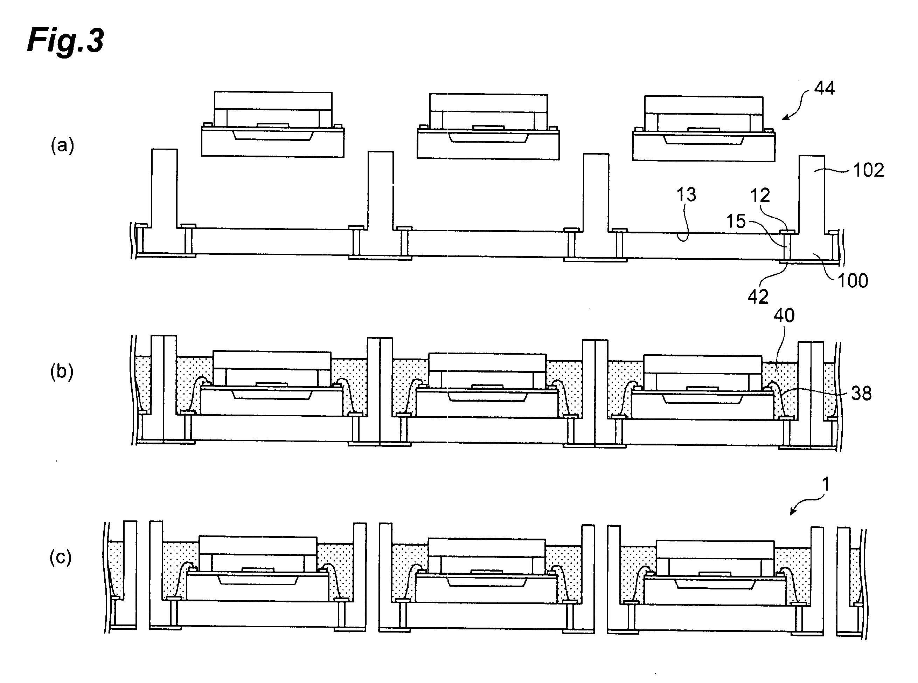

A method for manufacturing the infrared detector 1 according to the first embodiment shall now be described using FIG. 3. This manufacturing method is characterized in that individual infrared detectors 1 are obtained by dicing using a dicing saw, etc.

First, as shown in FIG. 3(a), a base member array plate 100 is prepared with which the internal lead terminals 12, the external lead terminals 42, and the conducting portions 15 connecting these terminals, have been formed in advance. On an upper surface of the array plate 100, walls 102 that are erected intersectingly at fixed intervals in the longitudinal and lateral directions are disposed and a plurality of spaces that are partitioned by these walls (these are the spaces in which the infrared detecting chips 20 and the optical window chips 30 are to be housed and shall be referred to hereinafter as "housing spaces") are arrayed. The walls 102 that surround the respective recessed portions arrayed on the base member array plate 100 become the wall plate portions 14 when the plate is cut into the individual infrared detectors 1. In each partitioned housing space, a joined unit 44 of the infrared detecting chip 20, the spacer 36, and the optical window chip 30, which has been prepared in advance, is positioned at a predetermined position of the mounting surface 13 and fixed by an adhesive, etc. The signal input/output terminals 25 of the infrared detecting chips 20, which have been fixed inside the respective housing spaces, and the internal lead terminals 12 of the base members 10 are then connected by the bonding wires 38.

Silicone resin is then injected into the respective housing spaces (see FIG. 3(b)). In this process, the silicone resin is injected to a position lower than the upper surfaces 30a (to 0.2mm below the upper surfaces 30a of the optical window chips 30 in the present embodiment) so that the resin does not flow onto the upper surfaces 30a of the optical window chips 30.

After then hardening the injected silicone resin by leaving, heating, illuminating ultraviolet rays, or other method, cutting is performed longitudinally and laterally along central lines in the alignment directions of the wall plate portions 14 as shown in FIG 3(c). Chip-shaped infrared detectors 1, such as shown in FIGS. 1 and 2, are thereby obtained. To facilitate the cutting, cuts, slits, etc., may be formed in advance along the central lines of the wall plate portions 14.

The infrared detector 1 according to the present embodiment that is manufactured by the manufacturing method described above exhibits the following actions and effects.

Firstly, the bonding wires 38 and other portions that readily receive mechanical impacts are incorporated in the interior of the coating member 40 and are thereby put in a protected state. The infrared detector 1 is thereby made high in impact resistance, and mounting onto various devices can be carried out readily and reliably. Also, because the internal lead terminals 12 are electrically connected to the external lead terminals 42 via the conducting portions 15, mounting onto various circuit substrates, etc., can be performed easily.

Operations of the infrared detector 1 according to the present embodiment shall now be described. When infrared rays, which are to be detected, are illuminated from the upper surface 30a side of the optical window chip 30, the infrared rays become absorbed by the infrared photosensitive portion 23 via the sealed space 34. The infrared photosensitive portion 23 rises in temperature in accordance with the amount of incident infrared rays, and the temperature of the diaphragm portion 22 also rises with this temperature rise. A temperature difference thus arises between the diaphragm portion 22 and the silicon substrate 21, and this temperature difference is manifested on the thermocouple hot contacts inside the infrared photosensitive portion 23 and the thermocouple cold contacts on the silicon substrate 21. An electromotive force arises across the hot contacts and the cold contacts due to the Seebeck effect, and the voltage thereof is applied to and measured by an external measurement circuit (not shown) via the signal input/output terminals 25 connected to the infrared photosensitive portion 23, the bonding wires 38, the internal lead terminals 12, the conducting portions 15, and the external lead terminals 42 of the base member 10. The amount of infrared rays made incident on the optical window chip 30 is thereby detected.

With the infrared detector 1 according to the present embodiment, because the silicon substrate 21, on which the cold contacts are formed, is coated by the coating member 40, heat is not released readily from the silicon substrate 21, and by the heat capacity thus being made large, temperature fluctuations in the silicon substrate 21 can be stabilized. Also because the sealed space 34 between the infrared detecting chip 20 and the optical window chip 30 is made large in volume by an amount corresponding to the thickness of the spacer 36, and heat release due to thermal conductance from the infrared photosensitive portion 23 to the optical window chip 30 is thus blocked, the heat insulating property of the infrared photosensitive portion 23 is improved. The heat exchange effectiveness of infrared rays to heat can thus be increased and the sensitivity of the infrared detector 1 as a sensor can be increased.

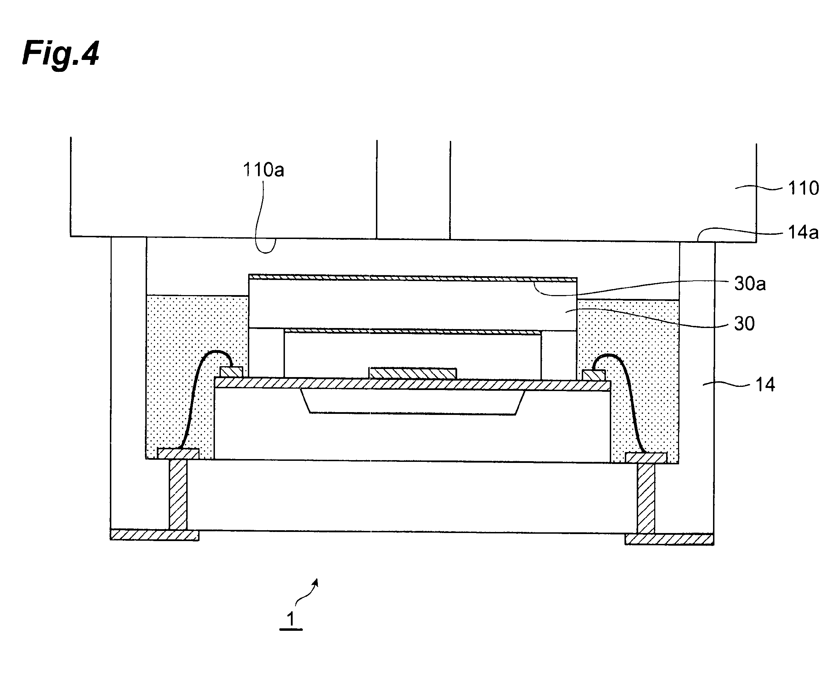

Also as shown in FIG. 4, because the infrared detector 1 according to the present invention has a structure, in which the top surface 14a of the wall plate portion 14 surpasses the upper surface 30a of the optical window chip 30, when the infrared detector 1 is picked up by a flat collet 110 and mounted onto another device, a tip surface 110a of the flat collet 110 contacts the top surface 14a of the wall plate portion 14 and does not directly contact the upper surface of the optical window chip. Damage due to contact with the flat collet 110 is thus prevented and a contribution toward improving the process yield is made.

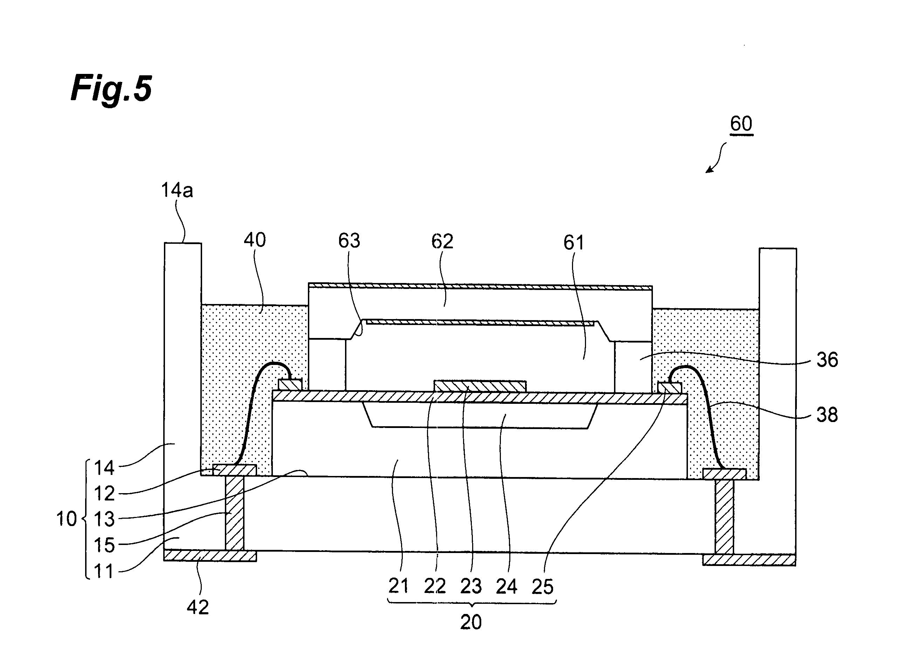

FIG. 5 is a sectional view of an arrangement of an infrared detector according to a second embodiment. A point of difference of the infrared detector 60 according to this embodiment with respect to the first embodiment is that an upwardly recessed portion 63 is formed by etching, etc., a region of a sealed space 61 side surface of an optical window chip 62 that opposes the infrared photosensitive portion 23. Because arrangements besides this are of the same structure as those of the first embodiment, description thereof shall be omitted. Also, because the method for manufacturing the infrared detector 60 according to the second embodiment is the same as the method for manufacturing of the first embodiment, description thereof shall be omitted.

With the present embodiment, the infrared detector 60 is made high in impact resistance and mounting onto various devices can be carried out readily and reliably as in the first embodiment described above. Also, due to being coated by the coating member 40, the silicon substrate 21 can be made high in heat capacity and temperature fluctuations in the silicon substrate 21 can be stabilized. Furthermore, due to the characteristic arrangement of the present embodiment, a larger volume can be secured for the sealed space 61. The infrared photosensitive portion 23 can thereby be heat insulated more readily and the sensitivity can be improved further. Also, even in a case where the optical window chip 62 with the recessed portion 63 and the infrared detecting chip 20 are joined directly and there is no spacer 36 or a case where the spacer 36 cannot be made high, the sealed space 61 can be secured and lowering of the sensitivity of the infrared detector 60 can be suppressed.

Although a single recessed portion 63 is formed in the present embodiment, the present invention is not restricted thereto, and a plurality of recessed portions 63 may be formed instead. Also, although in the present embodiment, the recessed portion 63 is formed in a region that opposes the infrared photosensitive portion 23, it may be formed in a region besides a region that opposes the infrared photosensitive portion 23.

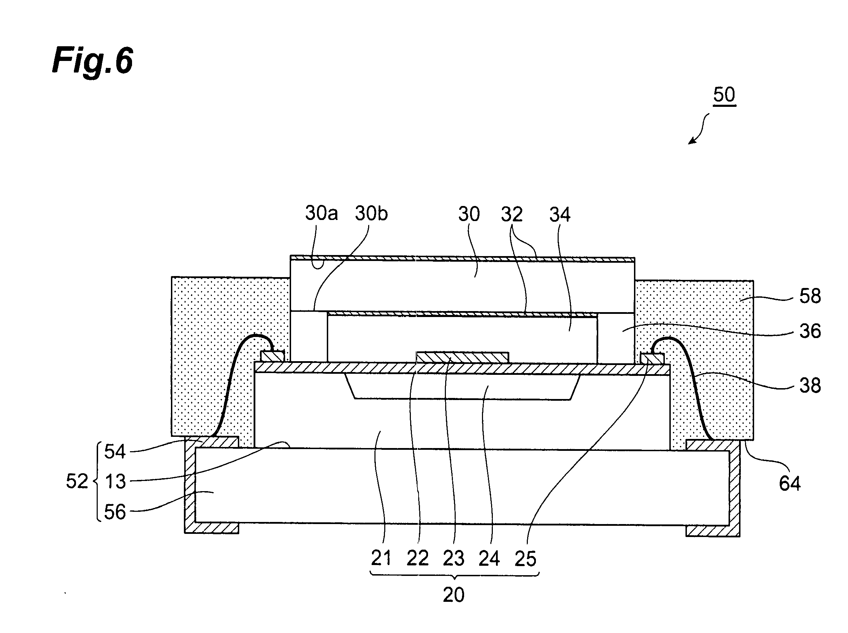

FIG. 6 is a sectional view of an arrangement of an infrared detector according to a third embodiment. Although as shown in this figure, the structure of the infrared detector 50 according to the third embodiment is basically the same as the structure of the infrared detector 1 according to the first embodiment described above, it differs in the structure of a base member 52.

That is, the base member 52 does not have a wall plate portion, and in place of the internal lead terminals 12, the external lead terminals 42, and the conducting portions 15, connecting these terminals, in the first embodiment described above, internal lead terminals 54, each passing through a substrate portion 56 and directly conducting both upper and lower surfaces of the substrate portion 56, are provided instead. The internal lead terminals 54 have a surface-mounted, square-C-like form or inverted square-C-like form and are fitted at respective ends of the substrate portion 56 so as to face each other. A portion below a predetermined distance from the upper surface 30a of the optical window chip 30 (0.2mm below the upper surface 30a of the optical window chip 30 in the present embodiment) is filled with a coating member 58. The coating member 58 protrudes outward beyond the internal lead terminals 54 of the base member 52 in directions perpendicular to the light-incident direction. A film 64 is fixed to a lower surface of this protruding portion.

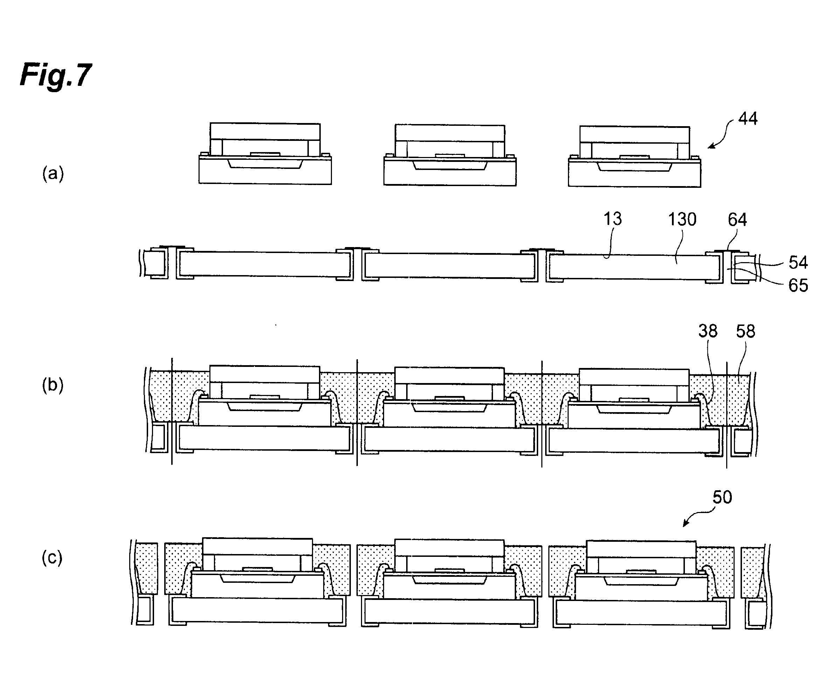

A method for manufacturing the infrared detector 50 according to the third embodiment shall now be described. First, as shown in FIG. 7(a), a base member base material 130, in which internal lead terminals 54 that penetrate through the substrate portions 56 are formed in advance, is prepared, and an outer frame (not shown) is set at a periphery so as to surround the base member base material 130 and form a housing space. In the housing space, the joined units 44 of the infrared detecting chip 20, the spacer 36, and the optical window chip 30, which have been prepared in advance, are positioned at predetermined positions of the mounting surface 13 and fixed by adhesion, etc. The signal input/output terminals 25 of each joined unit 44 and the internal lead terminals 54 of the base members 52 are then connected by the bonding wires 38. As shown in FIG. 7(a), films 64 are adhered so as to cover openings 65, which are formed by mutually adjacent internal lead terminals 54 of the base member 52, from the mounting surface 13 side.

Silicone resin is then injected into the housing space (see FIG. 7(b)). In this process, the silicone resin is injected to a position lower than the upper surfaces 30a (to 0.2mm below the upper surfaces 30a of the optical window chips 30 in the present embodiment) so that the resin does not flow onto the upper surfaces 30a of the optical window chips 30. Because the openings 65 are closed by the films 64, the resin does not flow into the openings 65. After then hardening the injected silicone resin by leaving, heating, illuminating ultraviolet rays, or other method, cutting is performed longitudinally and laterally along centers of the openings 65 as shown in FIG 7(c). Chip-shaped infrared detectors 50, such as shown in FIG 6, are thereby obtained.

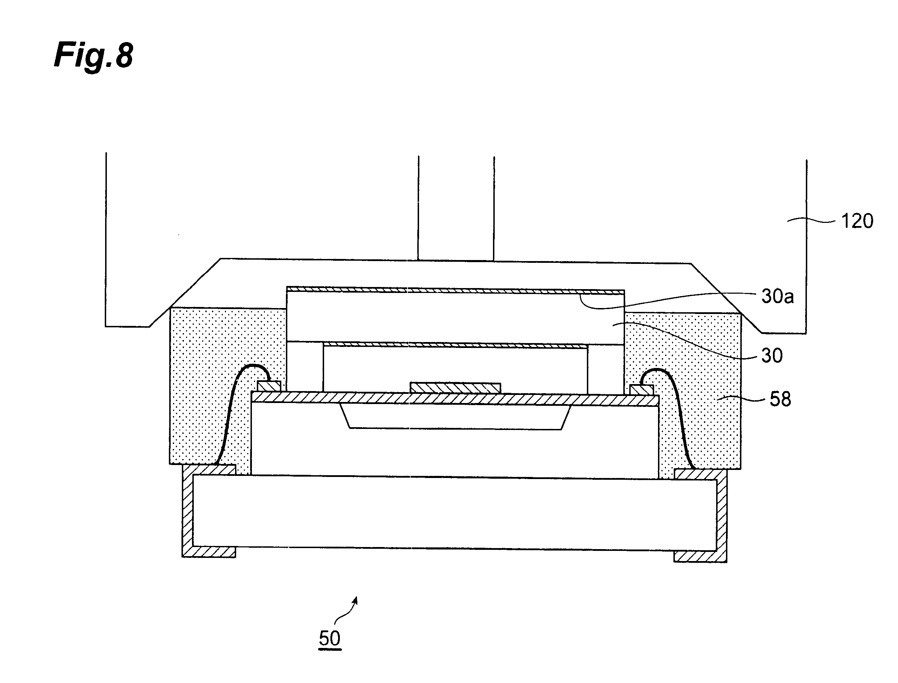

By the present embodiment, the same effects as those of the first embodiment are provided. That is, the infrared detector 50 is made high in impact resistance, can be mounted onto various devices readily and reliably, and can be increased in sensitivity as a sensor. Also because the present embodiment has the characteristic arrangement described above, when the infrared detector 50 according to the present invention is picked up by a pyramidal collet as shown in FIG. 8 to be mounted onto another device, the pyramidal collet 120 contacts the coating member 58 of the infrared detector 50 and because the pyramidal collet 120 thus does not directly contact the upper surface 30a of the optical window chip 30, damage due to contact with the pyramidal collet 120 is prevented and a contribution is made toward improving the process yield.

The present invention is not restricted to the embodiment described above. For example, although the internal lead terminals are of the land type in the embodiments, the internal lead terminals may be of the pin type instead.

Also though with each of the embodiments described above, the infrared detector is described as being a thermopile, a bolometer, pyroelectric sensor, diode, or bimetal type may be employed instead, and the same effects as those of the embodiments described above are obtained in these cases as well.

## Claims

1. An infrared detector comprising:
an infrared detecting chip, having an infrared photosensitive portion and a signal input/output terminal connected to the photosensitive portion, formed on a silicon substrate;
an optical window chip, being fixed to a photosensitive side of the infrared detecting chip, forming a sealed space that exposes the signal input/output terminal and houses the photosensitive portion, and transmits at least infrared rays that are to be detected;
a base member, having a mounting surface for mounting of the infrared detecting chip and provided with an internal lead terminal near the mounting surface;
a bonding wire, electrically connecting the signal input/output terminal with the internal lead terminal; and
a coating member, formed by injecting and hardening a resin so as to incorporate at least the signal input/output terminal, the internal lead terminal, and the bonding wire in its interior and coat at least the infrared detecting chip side of side surfaces of the optical window chip.

2. The infrared detector according to Claim 1, wherein a spacer is interposed between the infrared detecting chip and the optical window chip so as to surround the sealed space.

3. The infrared detector according to Claim 1 or 2, wherein a recessed portion is formed on a surface of the optical window chip at the sealed space side.

4. The infrared detector according to any one of Claims 1 to 3, wherein the base member includes a substrate portion, having the mounting surface at the upper surface, and a wall plate portion, erected on the substrate portion and having a top surface that surpasses the upper surface of the optical window chip.

5. The infrared detector according to any one of Claims 1 to 4, wherein the internal lead terminal is electrically connected to an external lead terminal disposed on a lower surface of the base member.
